# FASCICULE DE BREVET EUROPEEN

(11) **EP 0 747 159 B1**
(45) Date de publication et mention de la délivrance du brevet: **11.08.1999**
(21) Numéro de dépôt: 96401172.0
(22) Date de dépôt: 31.05.1996
(51) Int. Cl.: B23K 1/20, B23K 35/38

(54) **Procédé de fluxage par voie sèche de surfaces métalliques avant brasage ou étamage utilisant une atmosphère comportant de la vapeur d'eau.**
Verfahren zum Trockenfluxen von metallischen Fläschen vor dem Löten mit einer Atmosphäre die Wasserdampf enthält
Dry fluxing process of metallic surfaces before brazing, using an atmosphere comprising steam

(30) Priorité: 09.06.1995 FR 9506819
(43) Date de publication de la demande: 11.12.1996
(73) Titulaire: L'AIR LIQUIDE, SOCIETE ANONYME POUR L'ETUDE ET L'EXPLOITATION DES PROCEDES GEORGES CLAUDE, 75321 Paris Cédex 07 (FR)
(72) Inventeur: Sindzingre, Thierry, 94230 Cachan (FR); Rabia, Stéphane, 14 Résidence du Parc du Chateau d, 91190 Gif sur Yvette (FR); Potier, Nicolas, 75015 Paris (FR)
(74) Mandataire: Vesin, Jacques

(56) Documents cités:
- EP-A- 0 427 020
- EP-A- 0 557 756
- EP-A- 0 658 391
- GB-A- 2 274 286

## Description

La présente invention concerne l'opération de fluxage de surfaces métalliques intervenant généralement avant des opérations de brasage ou d'étamage en électronique. Elle s'applique ainsi notamment au fluxage intervenant avant les opérations :
- de brasage de composants sur circuit (qu'il s'agisse de composants insérés ou de composants montés en surface),
- de brasage de bandes de contacts sur supports électroniques, permettant la connexion du support en question sur un autre support (on peut considérer ici l'exemple d'un circuit hybride ou d'un circuit imprimé que l'on va insérer grâce à ces contacts dans un circuit imprimé, ou encore un circuit hybride ou imprimé que l'on va pouvoir enficher, grâce à ce peigne, dans un connecteur),
- de brasage de circuits dans des fonds de boîtiers (intervenant lors de l'encapsulation de tels circuits),
- de brasage intervenant lors de procédures de fermeture de boîtiers d'encapsulation,
- de brasage de puces nues sur supports tels que circuit imprimé, circuit hybrides ou encore substrats d'interconnexion multicouches tels que les substrats couramment appelés MCM (Multi Chip Modules),
- d'étamage circuits ou de terminaisons de composants électroniques.

On doit entendre par l'expression "étamage" des opérations de dépôts de couches dont la composition peut être très variée (incluant mais pas exclusivement le dépôt de couches du type étain-plomb).

Deux des méthodes les plus couramment utilisées pour effectuer de telles opérations de brasage (ou étamage) sont appelées "brasage (ou étamage) à la vague" et "brasage par refusion".

Dans le premier cas (machines de brasage à la vague), la conception de ces machines est telle que les pièces à braser ou à étamer sont amenées en contact avec une ou plusieurs vagues de soudure liquide obtenues par circulation du bain de soudure contenu dans un bac, au travers d'une ou plusieurs buses.

Dans le cas du second type de méthode (brasage par refusion), qui regroupe d'ailleurs sous ce vocable plusieurs techniques, on utilise non plus un bain de soudure liquide mais une pâte à braser, contenant l'alliage de brasure, qui est déposée sur le support (par exemple un circuit électronique avant dépôt des composants, les bords d'un boîtier à fermer ou encore un fond de boîtier), et à laquelle est apportée une certaine quantité de chaleur permettant d'obtenir la fusion de l'alliage métallique. Le plus souvent, ce transfert thermique est réalisé dans un four continu.

Le rôle de l'opération de fluxage avant brasage est alors de préparer les surfaces métalliques à braser ou étamer (réalisant des actions telles que dégraissage, désoxydation, décontamination de couches adsorbées ou autre préparation de surface), ceci dans le but de faciliter le mouillage ultérieur de ces surfaces par la soudure, mais également d'éliminer des oxydes qui pourraient se former au niveau de l'alliage de brasure.

Cette opération de fluxage est, le plus couramment, pratiquée à l'aide de flux chimiques, souvent obtenus à partir de bases résineuses, complétées notamment par des composés acides. Elle est réalisée, dans le cas d'une machine de brasage à la vague, dans une zone amont de la machine (donc avant que le support à traiter n'entre en contact avec la vague de soudure), ou bien, dans le cas du brasage par refusion, par le fait que le flux chimique entre dans la composition de la pâte à braser et la phase de fluxage est alors réalisée durant une première partie du cycle thermique utilisé.

Après brasage, demeurent alors sur la pièce des résidus de flux, obligeant souvent le fabricant à effectuer une opération de nettoyage, le plus souvent avec des solvants chlorés, très controversés dans le contexte du "Protocole de Montréal" et de ses révisions ultérieures.

Parmi les voies envisagées pour trouver une solution de remplacement à l'utilisation de ces composés, on peut citer des procédés de fluxage par voie sèche, tels que le fluxage plasma des surfaces avant brasage, évitant de ce fait l'utilisation de flux chimiques et donc la nécessité même d'une opération de nettoyage en aval. Les mélanges envisagés mettent notamment en oeuvre de l'hydrogène.

On peut citer dans ce domaine le document EP-A-0427020, qui propose d'effectuer un traitement des pièces d'assemblage à braser à l'aide d'un plasma d'un gaz de procédé, en recommandant l'utilisation de basses pressions pour ce traitement, "dans le but d'éviter un endommagement thermique des pièces d'assemblage". Tous les exemples donnés, en relation avec les figures fournies, concernent des conditions de pression se situant dans l'intervalle 30-100 Pa.

La même remarque peut être effectuée à propos du document EP-A-0371693 qui concerne un procédé de fluxage de surfaces métalliques avant brasage, par plasma micro-ondes contenant de l'hydrogène. Ici encore, il est recommandé d'utiliser des basses pressions "pour permettre de limiter le niveau d'oxygène résiduel dans le plasma".

Cette unanimité dans l'utilisation de conditions de basses pressions pour réaliser ces fluxages plasma, malgré les inconvénients liés notamment au coût d'obtention de telles pressions ou encore à la difficulté d'implantation des infrastructures correspondantes dans une chaîne de production industrielle est sans aucun doute liée à la difficulté technique et technologique d'obtention de plasmas à pression atmosphérique donnant des performances comparables à ce qui est traditionnellement obtenu à basse pression.

Dans ce contexte, la Demanderesse, avait, dans le document FR-A-2,697,456 proposé un procédé de fluxage plasma de surfaces métalliques avant brasage, à la pression atmosphérique, utilisant pour créer le plasma une source de micro-ondes ou encore une décharge à barrière diélectrique transférée via des lumières placées de façon adéquate dans une couche diélectrique placée au dessus de la pièce à traiter. Si ce document apporte une réponse intéressante au problème considéré, la Demanderesse a mis en évidence le fait que le procédé proposé pouvait être amélioré, notamment en ce qui concerne :
- son rendement (rapport de la puissance introduite pour créer le plasma à la densité d'espèces produites qui interagissent effectivement avec le support à traiter), ou encore la densité d'énergie admissible (dans le cas de la décharge à barrière diélectrique, elle n'atteint que quelques W par cm² de diélectrique) qui si ils étaient accrus pourraient permettre des temps de traitement plus courts;
- mais aussi du fait de facteurs "géométriques" limitants : dans le cas de la décharge couronne, la distance électrode/échantillon est tout à fait critique et doit être maintenue très faible, ce qui peut poser problème dans le cas de substrats dont le relief est relativement tourmenté; dans le cas de la décharge micro-ondes, elle donne lieu à la formation d'un spot plasmagène, de dimensions déterminées et limitées par la source plasma;
- par ailleurs, un plasma tel que celui créé dans ce document, contient par définition des espèces ioniques et des électrons (donc des espèces électriquement chargées) dont l'emploi est toujours délicat sur des composants électroniques.

En poursuivant ses travaux sur ce sujet, la Demanderesse a alors plus récemment proposé, dans le document EP-A-0658391, qui est compris dans l'état de la technique au sens de l'article 54.3 CBE, un procédé amélioré de fluxage par voie sèche d'une surface métallique avant brasage ou étamage à l'aide d'un alliage, remarquable en ce qu'il met en oeuvre les étapes suivantes :
a) on fait passer un mélange gazeux initial comprenant un gaz inerte et/ou un gaz réducteur et/ou un gaz oxydant, dans au moins un appareil de formation d'espèces gazeuses excitées ou instables, pour obtenir en sortie d'appareil, un mélange gazeux primaire;
b) on traite la surface à fluxer, à une pression voisine de la pression atmosphérique, par une atmosphère gazeuse de traitement comprenant des espèces excitées ou instables et substantiellement dépourvue d'espèces électriquement chargées, obtenue à partir du mélange gazeux primaire considéré.

Les exemples développés dans ce document démontraient clairement qu'il est possible, par ce procédé, notamment :
- d'opérer sensiblement à pression atmosphérique,
- d'obtenir une grande flexibilité de distance entre l'objet à traiter et le dispositif utilisé pour effectuer ce traitement,
- d'éviter le contact des pièces avec des espèces chargées,
- d'offrir une densité énergétique améliorée, permettant d'atteindre une vitesse de traitement accrue.

L'atmosphère de traitement qui est obtenue à partir du mélange gazeux primaire, lui même obtenu à la sortie de gaz d'un appareil de formation d'espèces gazeuses excitées ou instables, peut d'ailleurs selon ce document également comprendre le cas échéant un mélange gazeux adjacent n'ayant pas transité par l'appareil.

On peut donc qualifier cette configuration de "post-décharge" puisque la composante primaire de l'atmosphère de traitement, qui comprend des espèces gazeuses excitées ou instables, est obtenue en sortie d'appareil, ce qui assure l'absence substantielle de toute espèce électriquement chargée dans cette composante primaire. La composante adjacente de l'atmosphère de traitement, qui n'a pas transité par l'appareil, en est à fortiori dépourvue.

Par ailleurs, cette configuration permet de nettement séparer le lieu de la génération de la composante primaire de l'atmosphère du lieu de son utilisation, ce qui présente un avantage non négligeable en terme de pollution de l'appareil (éviter que les dégagements divers résultant de l'opération de fluxage de la surface n'aillent polluer l'intérieur de l'appareil, par exemple ses électrodes), mais également de reproductibilité de l'atmosphère rencontrée par la pièce.

Enfin, la pièce, qui n'est pas traitée au sein de l'appareil (par exemple au sein de la décharge entre les électrodes), bénéficie d'une bien meilleure flexibilité sur l'aspect "distance" évoqué plus haut.

Ce procédé était, dans ce document, tout particulièrement exemplifié et illustré à l'aide d'un dispositif particulier de formation de molécules gazeuses excitées ou instables, fonctionnant sensiblement à la pression atmosphérique, que la Demanderesse avait précédemment développé et qui est décrit dans le document FR-A-2,692,730.

La Demanderesse a depuis poursuivi ses travaux sur ce sujet, en vu d'améliorer encore le procédé de fluxage par voie sèche d'une surface métallique avant brasage ou étamage selon le document EP-A-0658391, notamment avec l'objectif d'abaisser encore le taux de défauts des produits (par exemple des circuits imprimés) obtenus en sortie de l'étape ultérieure de brasage ou d'étamage.

Ces travaux ont alors clairement, et de façon totalement inattendue, démontré que l'espèce "vapeur d'eau" H₂O pouvait jouer un rôle spécifique et particulièrement avantageux dans les performances de fluxage obtenues et donc de brasage ultérieur (par exemple à la vague).

Le procédé de fluxage par voie sèche d'une surface métallique avant brasage ou étamage à l'aide d'un alliage, selon la présente invention, se caractérise alors en ce que :
a) on fait passer un mélange gazeux initial comprenant un gaz inerte et/ou un gaz réducteur, et comportant un mélange gazeux oxydant qui comporte de la vapeur d'eau, dans au moins un appareil de formation d'espèces gazeuses excitées ou instables, pour obtenir en sortie d'appareil, un mélange gazeux primaire, la teneur en vapeur d'eau du mélange gazeux initial étant comprise dans la gamme [50 ppm, 6 % ] ;
b) on traite la surface à fluxer, à une pression voisine de la pression atmosphérique, par une atmosphère gazeuse de traitement comprenant des espèces gazeuses excitées ou instables et substantiellement dépourvue d'espèces électriquement chargées, obtenue à partir du mélange gazeux primaire.

On entend par l'expression "surface métallique" selon l'invention, tout type de surface métallique pouvant intervenir dans de telles opérations de brasage ou d'étamage, qu'elle soit par exemple en acier, cuivre, aluminium, étain, plomb, étain-plomb, étain-plomb-argent, ou encore alliages tels que Kovar, cette liste n'étant bien entendue qu'indicative, nullement limitative. On peut aussi évoquer les différents types de finitions des circuits électroniques telles que préétamage, finition Ni-Au, ou encore cuivre passivé.

La pièce comportant la pièce à fluxer pourra consister en toute pièce pouvant intervenir dans de telles opérations de brasage ou d'étamage, qu'il s'agisse par exemple d'un circuit électronique sur lequel on a reporté des composants en vu de les braser (qu'il s'agisse de composants insérés ou de composants montés en surface), ou bien d'un couple bande de contacts/support électronique (brasage de la bande sur le support), ou encore de supports tels que circuit imprimé, circuit hybrides ou encore substrats d'interconnexion multicouches tels que les substrats couramment appelés MCM (Multi Chip Modules) sur lesquels on a reporté des puces nues afin d'y être brasées, ou bien encore de composants électroniques à étamer.

L'"alliage" de brasage ou d'étamage selon l'invention sera constitué par toute composition que l'on peut envisager pour de telles opérations (par exemple de brasage par refusion ou dans une machine de brasage à la vague, ou encore d'étamage à la vague), telles que par exemple Sn-Pb, Sn-Pb-Ag, Pb-In etc..

On entend par l'expression "pression voisine de la pression atmosphérique" selon l'invention, une pression se situant avantageusement dans l'intervalle [0,1 x 10⁵ Pa, 3 x 10⁵ Pa].

On entend par l'expression "espèces électriquement chargées" selon l'invention, des ions ou des électrons. Comme expliqué précédemment, l'atmosphère de traitement selon l'invention se distingue donc des atmosphères plasma antérieurement décrites dans la littérature par le fait qu'elle est substantiellement dépourvue d'espèces électriquement chargées, c'est à dire d'ions où d'électrons.

L'atmosphère de traitement, qui est obtenue à partir du mélange gazeux primaire, peut également comprendre le cas échéant un mélange gazeux adjacent, le mélange gazeux primaire étant obtenu à la sortie de gaz de l'appareil de formation d'espèces gazeuses excitées ou instables dans lequel a été transformé le mélange gazeux initial tandis que le mélange gazeux adjacent n'a lui pas transité par l'appareil.

Comme précédemment développé dans le paragraphe consacré au document EP-A-0658391 on peut qualifier cette configuration de "post-décharge" avec tous les avantages qui en découlent et qui ont déjà été énumérés.

Le gaz inerte peut par exemple consister en de l'azote, de l'argon, de l'hélium ou un mélange de tels gaz inertes. Le gaz réducteur peut par exemple consister en de l'hydrogène, du CH₄ ou encore de l'ammoniac ou un mélange de tels gaz réducteurs.

Outre la vapeur d'eau, le mélange gazeux oxydant peut par exemple également comporter de l'oxygène, ou du CO₂, ou encore du N₂O, ou un mélange de telles espèces.

La liste d'espèces données dans chaque catégorie n'étant bien entendu qu'indicative, nullement limitative.

L'appareil selon l'invention est constitué par tout dispositif permettant "d'exciter" un mélange gazeux initial, pour obtenir, après transformation dans l'appareil, en sortie de gaz de l'appareil, un autre mélange gazeux (qualifié de primaire) comportant des espèces instables ou excitées, ce dernier mélange gazeux étant substantiellement dépourvu d'espèces électriquement chargées. Un telle excitation pourra par exemple être obtenue par une décharge électrique, par exemple du type décharge couronne.

Le document FR-A-2,692,730 au nom de la Demanderesse précédemment évoqué décrit un appareil de formation de molécules gazeuses excitées ou instables convenant pour la mise en oeuvre du procédé selon la présente invention.

Comme il apparaîtra clairement à l'homme du métier à la lecture de la description précédente, la teneur en vapeur d'eau du mélange gazeux initial devra être adaptée dans chaque cas, notamment au contenu du reste du mélange gazeux initial (par exemple sa teneur en gaz réducteur, par exemple en hydrogène), mais également au type de pièce à traiter (par exemple au type d'état de surface donc de finition du circuit électronique à fluxer avant brasage à la vague).

Néanmoins, il est apparu que la teneur en vapeur d'eau du mélange gazeux initial est avantageusement comprise dans la gamme [50 ppm, 6%], préférentiellement dans la gamme [100 ppm, 1%] , et encore plus préférentiellement comprise dans la gamme [500 ppm, 5000 ppm].

Comme signalé précédemment, le mélange gazeux oxydant peut comprendre outre la vapeur d'eau, une autre espèce oxydante, par exemple l'oxygène. Dans ce dernier cas, la teneur en oxygène du mélange gazeux initial est préférentiellement maintenue inférieure à quelques centaines de ppm.

Selon une des mises en oeuvre de l'invention, le mélange gazeux initial consiste en un mélange azote/hydrogène/vapeur d'eau.

Selon une autre des mises en oeuvre de l'invention, le mélange gazeux initial consiste en un mélange azote/hydrogène/vapeur d'eau/oxygène.

Lorsque le mélange gazeux initial comporte de l'hydrogène, sa teneur en hydrogène sera avantageusement située dans la gamme [1000 ppm, 50 %], mais préférentiellement inférieure ou égale à 10 %.

Le procédé de fluxage selon l'invention permet d'effectuer le traitement à l'aide du mélange primaire obtenu en sortie de gaz d'un seul appareil, ou de plusieurs appareils placés en parallèle sur la largeur de la pièce à traiter, ou encore successivement à l'aide des mélanges primaires obtenus en sorties de gaz de plusieurs appareils placés en série.

De même, comme il apparaîtra clairement à l'homme du métier, le procédé selon l'invention s'applique selon les besoins exprimés par l'utilisateur tant au traitement d'une seule des faces de la pièce à traiter, qu'au cas où l'on doit fluxer la pièce sur ses deux faces. Dans ce dernier cas, il conviendra de disposer les appareils requis en regard de chaque face de la pièce.

Le mélange adjacent, selon l'invention, pourra être constitué de tout gaz ou mélange de gaz, par exemple d'un gaz inerte ou mélange de gaz inertes permettant de maintenir, le cas échéant, une atmosphère protectrice autour des échantillons, ou encore d'un gaz réducteur ou d'un gaz oxydant, voire d'un mélange de gaz appartenant à l'une de ces trois catégories.

Selon un autre aspect de l'invention, la surface à traiter est portée à une température comprise entre la température ambiante et la température de fusion de l'alliage utilisé pour effectuer l'opération de brasage ou étamage ultérieure. Cette borne haute dépendra donc de l'alliage utilisé, elle se situera par exemple au voisinage de 180 °C dans le cas des alliages Sn63-Pb37 ou Sn62-Pb36-Ag2 utilisés classiquement. Avantageusement, et selon le cas de chaque type de pièce ou support traité, afin de limiter la croissance d'intermétalliques, on s'efforcera d'adopter une température qui ne soit pas trop proche de la température de fusion de l'alliage utilisé, par exemple ne dépassant pas 160 °C dans le cas des alliages Sn63-Pb37 ou Sn62-Pb36-Ag2 utilisés.

Selon un des aspects de l'invention, la pièce comportant la ou les surfaces métalliques à traiter est amenée en regard de la sortie de gaz de l'appareil, le cas échéant, en regard des sorties de gaz de plusieurs appareils placés en parallèle sur la largeur de la pièce et/ou successivement en regard des sorties de gaz de plusieurs appareils placés en série, par un système de convoyage traversant un espace intérieur délimité par une structure de capotage (par exemple un tunnel ou un ensemble de capotages élémentaires), isolé de l'atmosphère environnante, la structure étant raccordée de façon étanche à ou aux appareils ou incluant le ou les appareils.

La même remarque déjà effectuée plus haut s'applique ici, sur le traitement en double faces (ici encore, il suffit de mettre en oeuvre les appareils requis, en nombre et en disposition, en regard de chaque face de la pièce).

Lorsque la pièce comportant la ou les surfaces métalliques à traiter est amenée en regard des sorties de gaz de plusieurs appareils placés en parallèle sur la largeur de la pièce et/ou successivement en regard des sorties de gaz de plusieurs appareils placés en série, au moins un des ces appareils transforme un mélange gazeux initial qui comprend un gaz inerte et/ou un gaz réducteur, et un mélange gazeux oxydant qui comporte de la vapeur d'eau. Le mélange gazeux initial transformé au niveau des autres appareils pourra alors comprendre un gaz inerte et/ou un gaz réducteur et/ou un gaz oxydant.

Selon une des mises en oeuvre de l'invention, l'appareil (ou au moins un des appareils), dans lequel est transformé le mélange gazeux initial, est le siège d'une décharge électrique créée entre une première électrode et une seconde électrode, une couche d'un matériau diélectrique étant disposée sur la surface d'au moins une des électrodes, en regard de l'autre électrode, le mélange gazeux initial traversant la décharge transversalement aux électrodes.

L'énergie mise en oeuvre dans l'appareil, ramenée à l'unité de surface de diélectrique sera alors avantageusement supérieure ou égale à un 1W/cm², préférentiellement supérieure ou égale à 10W/cm², le plus souvent dans l'intervalle [10 W/cm², 100 W/cm²]

Selon une des mises en oeuvre de l'invention, on réalise un zonage de l'atmosphère de traitement rencontrée successivement par la pièce à traiter le long du convoyeur, de la façon suivante :
a) au moins un des appareils de formation d'espèces gazeuses excitées ou instables, transforme un mélange gazeux initial différent de celui transformé par l'appareil le précédant dans la dite structure, et/ou
b) le mélange gazeux adjacent mis en oeuvre au niveau d'au moins un des appareils de formation d'espèces gazeuses excitées ou instables est différent de celui mis en oeuvre au niveau de l'appareil le précédant dans la dite structure.

Selon une des mises en oeuvre de l'invention, les étapes a) et b) ci-dessus pourront concerner un même appareil.

On pourra ainsi par exemple utiliser des mélanges de pouvoir réducteur croissant, d'un appareil à l'autre.

Selon un des aspects de l'invention, en sortie de la structure, la pièce entre dans une machine où est effectuée l'opération de brasage ou d'étamage, la pièce étant, le cas échéant, entre la sortie de la structure et l'entrée de la machine, maintenue sous atmosphère protectrice. On entend alors par atmosphère protectrice, une atmosphère essentiellement inerte, dont la concentration résiduelle d'oxygène n'excède par quelques centaines de ppm, voire 100 ppm.

Selon un autre aspect de l'invention, l'opération de brasage ou d'étamage est réalisée au sein de la structure de capotage même (par exemple un tunnel), en aval de l'appareil.

Selon une des mises en oeuvre de l'invention, l'opération de brasage ou d'étamage, avant laquelle intervient le fluxage selon l'invention, est réalisée à la vague, et la pièce comportant la surface métallique à traiter est un circuit électronique, dont chaque face est amenée en regard de la sortie de gaz d'au moins un appareil de formation d'espèces gazeuses excitées ou instables par le système de convoyage.

Avantageusement, la face supérieure du circuit électronique à traiter est amenée successivement en regard des sorties de gaz d'au moins deux appareils de formation d'espèces gazeuses excitées ou instables.

Dans ce cas d'application de l'invention au cas du fluxage avant brasage à la vague, il convient de signaler (que l'opération de brasage soit réalisée dans une machine séparée en aval, ou au sein de la même structure de capotage), que l'opération de fluxage selon l'invention pourra être couplée à l'étape de préchauffage des circuits ou supports présente habituellement dans les machines de brasage à la vague entre l'étape de fluxage chimique et le pot de soudure. On pourra alors envisager selon l'invention des successions du type :
- un fluxage selon l'invention (à froid ou à chaud) suivi d'une opération de préchauffage (suivi du brasage ou étamage);
- une opération de préchauffage suivie d'un fluxage selon l'invention (à froid ou à chaud) (suivi du brasage ou étamage);
- un fluxage selon l'invention (à froid), suivi d'une opération de préchauffage, suivie d'un fluxage selon l'invention (à chaud) (suivi du brasage ou étamage),
   cette liste de successions n'étant bien entendu qu'illustrative des nombreuses possibilités qu'offre l'invention, nullement limitative.

En aval de la mise en contact du circuit avec la ou les vagues de soudure, donc en aval de l'opération de brasage proprement dite, on pourra le cas échéant amener au moins une des faces du circuit en regard de la sortie de gaz d'au moins un appareil (que l'on peut qualifier de "aval") de formation d'espèces gazeuses excitées ou instables dans lequel on fait passer un mélange gazeux initial (que l'on peut ici encore qualifier de "aval") comprenant un gaz inerte et/ou un gaz réducteur et/ou un gaz oxydant, pour obtenir en sortie de gaz de l'appareil, un mélange gazeux primaire "aval" comprenant des espèces excitées ou instables et substantiellement dépourvu d'espèces électriquement chargées, ceci permettant si nécessaire d'effectuer un post-nettoyage de la surface du circuit.

On peut également envisager que durant tout ou partie de la mise en contact avec la ou les vagues de soudure, au moins une des faces du circuit soit mise en contact avec la sortie de gaz d'au moins un appareil que l'on peut qualifier de "supplémentaire" de formation d'espèces gazeuses excitées ou instables dans lequel on fait passer un mélange gazeux initial (que l'on peut également qualifier de "supplémentaire") comprenant un gaz inerte et/ou un gaz réducteur et/ou un gaz oxydant, pour obtenir en sortie de gaz de l'appareil, un mélange gazeux primaire "supplémentaire" comprenant des espèces gazeuses excitées ou instables et substantiellement dépourvu d'espèces électriquement chargées.

Comme il apparaîtra clairement à l'homme du métier, ce traitement "supplémentaire", réalisé durant le brasage même, peut apparaître très avantageux en vu notamment d'éliminer substantiellement les oxydes qui pourraient se former au niveau de l'alliage de brasure.

Selon un aspect de l'invention, on prévoit la mise en place d'un régime que l'on peut qualifier de "veille" du traitement réalisé selon l'invention avant brasage ou étamage, quand l'opération de brasage ou d'étamage doit être provisoirement arrêtée.

On pourra ainsi prévoir selon l'invention des situations dans lesquelles, par exemple suite à une action volontariste de l'utilisateur, ou encore du fait qu'aucun circuit ou pièce n'a été détecté à l'entrée de la structure durant une période de temps qui a été prédéfinie, on déclenche au moins l'une des mesures suivantes :
- on stoppe l'alimentation de chaque appareil en mélange gazeux primaire;
- on maintient dans chaque appareil un débit réduit du mélange gazeux primaire qui circule dans l'appareil considéré (par exemple quelques % ou quelques dizaines de % du débit circulant en régime nominal utilisé pour le traitement);
- quand un mélange gazeux adjacent est mis en oeuvre au niveau d'au moins l'un des appareils, on stoppe l'alimentation en mélange gazeux adjacent au niveau d'au moins l'un de ces appareil;
- on fait passer, dans chaque appareil, en lieu et place du mélange gazeux primaire qui circule dans l'appareil considéré, un mélange gazeux primaire que l'on peut qualifier d' "attente" (par exemple un gaz neutre ou encore un mélange gaz neutre/hydrogène...);
- on bascule chaque appareil du régime de traitement où il se trouvait à un régime d'attente où la densité d'énergie qui y est mise en oeuvre n'est que de quelques W/cm².

D'autres caractéristiques et avantages de la présente invention ressortiront de la description suivante de modes de réalisation donnée à titre illustratif mais nullement limitatif, faite en relation avec les dessins annexés, sur lesquels :
- la figure 1 est une représentation schématique d'une installation convenant pour la mise en oeuvre du procédé selon l'invention.
- la figure 2 représente schématiquement en coupe un exemple d'appareil de formation d'espèces gazeuses excitées ou instables convenant pour la mise en oeuvre du procédé selon l'invention.
- la figure 3 est une représentation schématique d'une autre installation convenant pour la mise en oeuvre du procédé selon l'invention, où un circuit électronique, devant être ultérieurement brasé dans une machine de brasage à la vague, rencontre successivement, dans une structure de capotage ici du type tunnel, trois appareils de formation d'espèces gazeuses excitées ou instables en série, deux de ces appareils sur sa face supérieure, et le troisième appareil sur sa face inférieure.

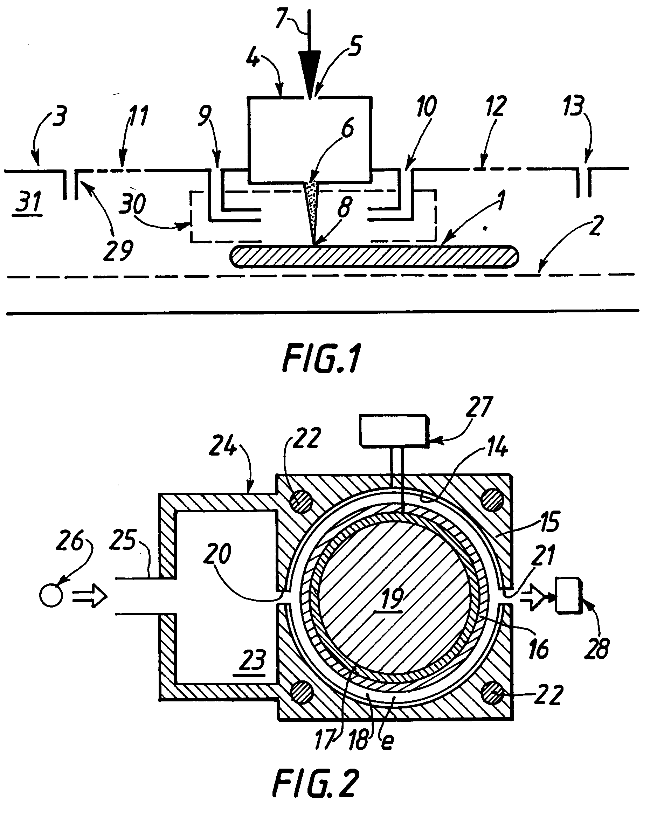

On reconnaît sur la figure 1, la présence d'une pièce 1, comportant la ou les surfaces métalliques à fluxer, amenée grâce à un tapis de convoyage 2, en regard de la sortie de gaz 6 d'un appareil 4 de formation d'espèces gazeuses excitées ou instables.

Le système de convoyage 2 traverse un espace intérieur 31, délimité par un tunnel 3, raccordé avantageusement de façon étanche à l'appareil 4.

On a schématisé en 8 le mélange gazeux primaire obtenu en sortie 6 de l'appareil. Le mélange gazeux primaire 8 est obtenu à partir d'un mélange gazeux initial 7 entrant dans l'appareil au niveau de son entrée de gaz 5.

On note aussi sur le mode de réalisation représenté sur la figure 1 la présence d'entrées de mélanges gazeux adjacents 9, 10. L'atmosphère gazeuse obtenue à partir des mélanges gazeux adjacents 9, 10 et du mélange gazeux primaire 8 constitue l'atmosphère 30 de traitement selon l'invention.

On note sur le mode de réalisation représenté sur la figure 1, la présence d'appareils de formation d'espèces gazeuses excitées ou instables supplémentaires, non représentés, en 11 et 12, en série avec le premier appareil 4 et que rencontre successivement la pièce 1.

L'installation se complète alors le cas échéant par d'autres entrées de mélange de gaz adjacent telles que celles représentées en 13 et 29.

L'installation est par ailleurs pourvue, le cas échéant, d'un moyen de chauffage de la pièce 1, non représenté sur la figure 1. On pourra par exemple envisager, pour ce moyen de chauffage, des lampes infrarouge présentes dans le tunnel, ou un chauffage par convection (parois chaudes du tunnel) ou encore le fait que la pièce soit posée sur un porte-substrat chauffant.

Comme représenté sur le mode de réalisation de la figure 2, l'appareil de formation d'espèces gazeuses excitées ou instables pour ce mode de réalisation est de géométrie cylindrique, il comprend une première électrode tubulaire 14, formée par exemple par une face interne d'un bloc métallique 15, et dans laquelle est disposé concentriquement un ensemble d'un tube en matériau diélectrique 16, par exemple en céramique, sur la face interne duquel est déposée, par métallisation, une deuxième électrode 17, exagérément épaissie sur la figure 2 pour une meilleure compréhension.

L'ensemble du diélectrique 16 et de la deuxième électrode 17 défini ainsi, avec la première électrode 14, un passage tubulaire de gaz 18, et, intérieurement, un volume interne 19 dans lequel on fait circuler un réfrigérant, avantageusement un Fréon pour son caractère électronégatif ou encore de l'eau permutée. Le passage de gaz interne 18 a une extension axiale inférieure à 1 m, typiquement inférieure à 50 cm, et son épaisseur radiale e n'excède pas 3 mm et est typiquement inférieure à 2,5 mm.

Le bloc 15 comporte, sensiblement diamétralement opposées, deux fentes longitudinales 20 et 21 formant respectivement l'entrée du gaz initial à exciter dans le passage 18 et la sortie du flux de gaz primaire comportant des espèces gazeuses excitées ou instables.

Les fentes 20 et 21 s'étendent sur toute la longueur axiale de la cavité 18 et ont une largeur qui pour le mode de réalisation représenté figure 2, n'excède pas l'épaisseur e et est typiquement sensiblement identique à cette dernière. Le corps 15 comporte avantageusement, à la périphérie de la première électrode 14, une pluralité de conduits 22 pour le passage d'un réfrigérant, par exemple de l'eau. L'entrée de gaz 20 communique avec une chambre ou plénum d'homogénéisation 23 formée dans un boîtier 24 accolé au bloc 15 et comportant une tubulure 25 d'amenée de gaz initial, en provenance d'une source de gaz initial 26, et donc à une pression qui pourra varier selon cette source typiquement de quelques bars à 100 ou 200 bars. Les électrodes 14 et 17 sont reliées à un générateur électrique haute tension et haute fréquence 27, fonctionnant à une fréquence avantageusement supérieure à 15 kHz, délivrant une puissance par exemple de l'ordre de 10 kW. On pourra d'ailleurs avantageusement exprimer cette puissance délivrée par le générateur en la ramenant à la surface de diélectrique.

Le flux gazeux contenant les espèces excitées, disponible à la sortie de gaz 21, est adressé à un poste utilisateur 28, par exemple pour le fluxage de surfaces métalliques selon l'invention.

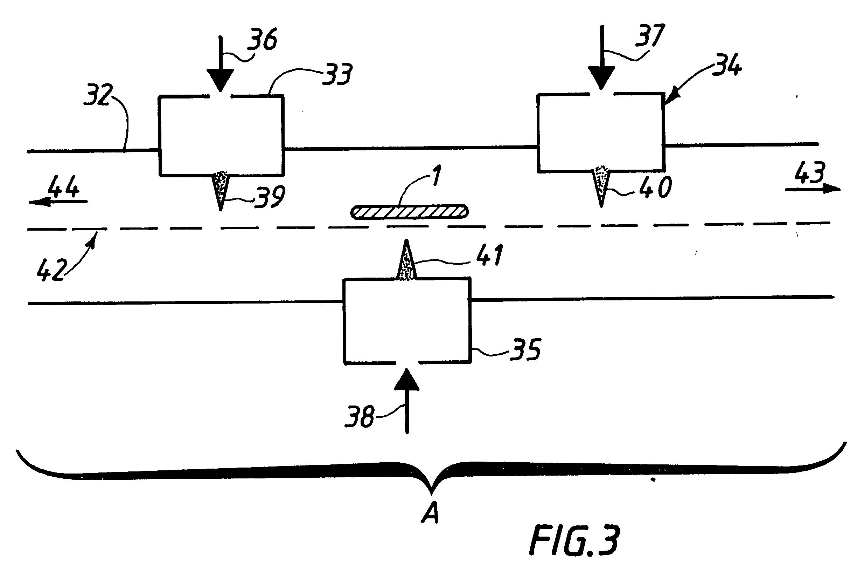

L'installation schématisée figure 3 illustre le cas d'une installation de fluxage selon l'invention, intervenant avant une opération ultérieure qui peut être par exemple une opération de brasage à la vague. Chaque circuit à braser est ici convoyé à l'intérieur d'un tunnel 32, le long d'une direction 42. Le système de préhension des circuits (par exemple du type comportant deux chaînes de doigts agrippant le circuit de part et d'autre du tunnel) n'a pas été représenté pour des raisons de clarté mais de tels systèmes de convoyage sont largement connus de l'homme du métier des machines de brasage à la vague.

Le circuit rencontre alors successivement les sorties de gaz de trois appareils de formation d'espèces gazeuses excitées ou instables 33, 34, 35 (où sont traités respectivement les mélanges gazeux du type initial 36, 37, 38), et plus précisément les mélanges primaires en résultant 39, 41 et 40. Les mélanges primaires 39 et 40 traitant plus spécifiquement la face supérieure du circuit tandis que le mélange primaire 41 traite plus spécifiquement la face inférieure de ce circuit.

L'installation de la figure 3 a été représentée indépendamment de toute machine de brasage à la vague mais comme largement développé plus haut, on peut envisager de nombreux agencements possibles de cette installation :
- le fait par exemple qu'en sortie de cette installation et de la structure de tunnel 32 qu'elle comporte, le circuit entre dans une machine de brasage à la vague (direction référencée 43), le circuit étant, entre la sortie du tunnel et l'entrée de la machine le cas échéant maintenu sous atmosphère protectrice;
- ou encore le fait que fluxage selon l'invention et opération de brasage ou d'étamage sont réalisés au sein de la même structure de tunnel 32 (le bac de soudure étant situé en aval du fluxage et donc en aval du dernier appareil rencontré 34). On a alors symbolisé par la référence 44 la direction de l'entrée de la machine et par la référence 43 la direction de localisation du bain de soudure.

Comme détaillé précédemment, l'ensemble A constitué de la portion de tunnel incorporant les trois appareils de formation d'espèces gazeuses excitées ou instables 33, 34, 35 sera alors nécessairement situé en amont du bain de soudure, mais pourra être situé selon les cas en amont ou en aval d'une étape de préchauffage des circuits.

Une installation telle que celle décrite en relation avec la figure 3, intégrant trois appareils tels que celui décrit en relation avec la figure 2, a été utilisée pour la réalisation d'exemples de mise en oeuvre de l'invention ainsi que des exemples comparatifs rapportés ci-dessous.

Les conditions communes de mise en oeuvre de ces exemples sont les suivantes :
- l'installation de la figure 3 était intégrée au sein d'une machine de brasage à la vague (dont le fluxeur chimique avait été supprimé) tunnelée sur toute sa longueur, entre une zone de préchauffage (maintenant une température au niveau des circuits de l'ordre de 150 à 160°C) et le pot de soudure Sn63-Pb37,
- vitesse de convoyage des circuits au niveau de chaque appareil : 8 cm/min,
- chaque appareil met en oeuvre une puissance de l'ordre de 3 kW, correspondant à une densité de puissance de l'ordre de 35 W/cm²;
- au niveau de chacun des trois appareils, le circuit était chauffé (température des circuits maintenue à un niveau de l'ordre de 150 à 160°C) par la présence en vis à vis de chaque appareil d'un tube radiant (au niveau de chaque appareil, le circuit est donc situé "en sandwich" entre l'appareil et un tube radiant non représenté sur la figure 3),
- les circuits fluxés et brasés à la vague étaient du type circuits imprimés (PCB) préétamés, double face à trou métallisés, comportant des composants des deux catégories "montés en surface" et "insérés à fil";
- pour chaque exemple décrit ci-dessous, on a dénombré pour chaque circuit brasé le nombre de défauts de brasure sur les composants à fils, particulièrement délicats à traiter (défaut de remontée de la brasure dans les trous métallisés). Chaque exemple donne alors la moyenne du nombre de défauts observés par carte, pour au moins 10 cartes brasées, et sachant qu'une carte comporte 100 points de brasure du type "trou métallisé".

Pour le premier exemple de mise en oeuvre, les conditions d'opération et les résultats obtenus sont les suivants :
- mélange initial transformé dans le premier et second appareil : 17 m³/h d'un mélange N₂/H₂ à 4 % d'hydrogène;
- mélange initial transformé dans le troisième appareil (34) : 17 m³/h d'un mélange N₂/H₂/H₂O, à 4 % d'hydrogène et 1000 ppm H₂O,
- taux de défauts moyen : < 10 %

Pour le second exemple les conditions d'opération et les résultats obtenus sont les suivants :
- mélange initial transformé dans chacun des trois appareils : 17 m³/h d'un mélange N₂/H₂ à 4 % d'hydrogène;
- taux de défauts moyen : ≈ 40 %

Pour un troisième exemple, les conditions d'opération et les résultats obtenus sont les suivants :
- mélange initial transformé dans le premier et second appareil : 17 m³/h d'un mélange N₂/H₂ à 4 % d'hydrogène;
- mélange initial transformé dans le troisième appareil (34) : 17 m³/h d'un mélange N₂/H₂/H₂O, à 4 % d'hydrogène et 6000 ppm H₂O,
- taux de défauts moyen : ≈ 65 %

Pour un quatrième exemple, les conditions d'opération et les résultats obtenus sont les suivants :
- mélange initial transformé dans le premier et second appareil : 17 m³/h d'un mélange N₂/H₂ à 4 % d'hydrogène;
- mélange initial transformé dans le troisième appareil (34) : 17 m³/h d'un mélange N₂/H₂O, à 400 ppm H₂O,
- taux de défauts moyen : avoisinant les 100 %

Les résultats décrits ci-dessus illustrent l'amélioration très sensible des résultats observés sur les points du circuit les plus difficiles à braser (composants à fil, trous métallisés) en présence de vapeur d'eau dans le mélange initial traité dans un des appareils.

Comme précédemment évoqué, la teneur en vapeur d'eau du mélange gazeux initial doit être adaptée dans chaque cas, notamment au contenu du reste du mélange gazeux initial (ici à la teneur en hydrogène adoptée), mais également au type de pièce à traiter (ici à la complexité des joints de brasure à réaliser et à la finition du circuit électronique utilisée).

En l'occurrence, il apparaît qu'ici, en tenant compte de l'ensemble des conditions pratiquées, il est avantageux de situer la teneur en vapeur d'eau du mélange gazeux initial au voisinage de 1000 ppm, donc comprise dans la gamme [500 ppm, 5000 ppm].

On constate également que pour le cas proposé, il est souhaitable d'assurer la présence de quelques % d'hydrogène dans le mélange gazeux initial, 4% représentant une concentration très raisonnable et acceptable tant sur le plan économique que sur le plan de la sécurité.

Des essais comparatifs (toute autre condition maintenue constante) pour ce même circuit ont permis de démontrer qu'une augmentation de la teneur en hydrogène (par exemple à 20%) n'améliorait pas de façon significative les résultats.

Quoique la présente invention ait été décrite en relation avec des modes de réalisation particuliers, elle ne s'en trouve pas limitée pour autant mais est au contraire susceptible de modifications et de variantes qui apparaîtront à l'homme de l'art.

## Revendications

1. Procédé de fluxage par voie sèche d'au moins une surface métallique d'une pièce, avant brasage ou étamage à l'aide d'un alliage, caractérisé en ce que :
a) on fait passer un mélange gazeux initial (7) comprenant un gaz inerte et/ou un gaz réducteur, et comportant un mélange gazeux oxydant qui comporte de la vapeur d'eau, dans au moins un appareil (11,4,12) de formation d'espèces gazeuses excitées ou instables, pour obtenir, après transformation dans l'appareil, en sortie de gaz (6) de l'appareil, un mélange gazeux primaire (8, 39, 40, 41), la teneur en vapeur d'eau du mélange gazeux initial étant comprise dans la gamme [50 ppm, 6 %] ;
b) on traite la surface à fluxer, à une pression voisine de la pression atmosphérique, par une atmosphère gazeuse de traitement comprenant des espèces gazeuses excitées ou instables et substantiellement dépourvue d'espèces électriquement chargées, obtenue à partir du dit mélange gazeux primaire.

2. Procédé selon la revendication 1, caractérisé en ce que ladite atmosphère gazeuse de traitement est obtenue à partir dudit mélange gazeux primaire et d'un mélange gazeux adjacent (9,10) qui n'a pas transité par le dit appareil.

3. Procédé selon l'une des revendications 1 ou 2, caractérisé en ce que la teneur en vapeur d'eau du mélange gazeux initial est comprise dans la gamme [100 ppm, 1 %] ;

4. Procédé selon la revendication 3, caractérisé en ce que la teneur en vapeur d'eau du mélange gazeux initial est comprise dans la gamme [500 ppm, 5000 ppm] ;

5. Procédé selon l'une des revendications 1 à 4, caractérisé en ce que le dit mélange gazeux oxydant comprend outre de la vapeur d'eau, de l'oxygène.

6. Procédé selon l'une des revendications 1 à 4, caractérisé en ce que le dit mélange gazeux initial consiste en un mélange azote/hydrogène/vapeur d'eau.

7. Procédé selon la revendication 5, caractérisé en ce que le dit mélange gazeux initial consiste en un mélange azote/hydrogène/vapeur d'eau/oxygène.

8. Procédé selon l'une des revendications 1 à 5, caractérisé en ce que ledit mélange gazeux initial comprend de l'hydrogène et en ce que la teneur en hydrogène du dit mélange gazeux initial est situé dans la gamme [1000 ppm, 50%], préférentiellement inférieure ou égale à 10 %.

9. Procédé selon l'une des revendications 1 à 8, caractérisé en ce que durant le traitement, la pièce à traiter est portée à une température comprise entre la température ambiante et la température de fusion de l'alliage utilisé pour effectuer l'opération de brasage ou étamage ultérieure.

10. Procédé selon la revendication 9, caractérisé en ce que la température de fusion du dit alliage est voisine de 180 °C, et en ce que la dite température à laquelle est portée la pièce à traiter ne dépasse pas 160 °C.

11. Procédé selon l'une des revendications 1 à 10, caractérisé en ce que la pièce (1) comportant ladite au moins une surface métallique à traiter est amenée en regard de la sortie (6) de gaz du dit appareil (4), par un système de convoyage (2) traversant un espace intérieur (31) délimité par une structure de capotage (30), isolé de l'atmosphère environnante, ladite structure étant raccordée de façon étanche au dit appareil ou incluant le dit appareil.

12. Procédé selon l'une des revendications 1 à 10, caractérisé en ce que la pièce (1) comportant la dite au moins une surface métallique à traiter est amenée en regard des sorties de gaz de plusieurs appareils placés en parallèle sur la largeur de la pièce et/ou successivement en regard des sorties de gaz de plusieurs appareils (11, 4, 12) placés en série, par un système de convoyage (2) traversant un espace intérieur (31) délimité par une structure de capotage (30), isolé de l'atmosphère environnante, ladite structure étant raccordée de façon étanche aux dits appareils ou incluant les dits appareils.

13. Procédé selon la revendication 12, caractérisé en ce que au moins un des dits appareils transforme un mélange gazeux initial (7) qui comprend un gaz inerte et/ou un gaz réducteur, et un mélange gazeux oxydant qui comporte de la vapeur d'eau.

14. Procédé selon la revendication 11 ou 12, caractérisé en ce que le dit appareil ou au moins un des dits appareils est le siège d'une décharge électrique créée entre une première électrode (14) et une seconde électrode (17), une couche (16) d'un matériau diélectrique étant disposée sur la surface d'au moins une des électrodes (17), en regard de l'autre électrode, et en ce que le mélange gazeux initial qui est transformé dans cet appareil traverse la décharge transversalement aux électrodes.

15. Procédé selon la revendication 14, caractérisé en ce que l'énergie mise en oeuvre dans le dit appareil, ramenée à l'unité de surface de diélectrique est supérieure ou égale à 1 W/cm², préférentiellement supérieure ou égale à 10W/cm².

16. Procédé selon la revendication 12, dans son rattachement à la revendication 1, caractérisé en ce que l'on réalise un zonage de l'atmosphère de traitement rencontrée successivement par la pièce à traiter le long du convoyeur, de la façon suivante : au moins un des appareils (11, 4, 12) de formation d'espèces gazeuses excitées ou instables transforme un mélange gazeux initial (7) différent de celui transformé par l'appareil le précédant dans ladite structure (3).

17. Procédé selon la revendication 12 dans son rattachement à la revendication 2, caractérisé en ce que l'on réalise un zonage de l'atmosphère de traitement rencontrée successivement par la pièce à traiter le long du convoyeur, de la façon suivante :
a) au moins un des appareils (11, 4, 12) de formation d'espèces gazeuses excitées ou instables transforme un mélange gazeux initial (7) différent de celui transformé par l'appareil le précédant dans ladite structure (3), et/ou
b) le mélange gazeux adjacent (9, 10) mis en oeuvre au niveau d'au moins un des appareils (11, 4, 12) de formation d'espèces gazeuses excitées ou instables est différent de celui mis en oeuvre au niveau de l'appareil le précédant dans ladite structure (3).

18. Procédé selon la revendication 17, caractérisé en ce que les étapes a) et b) ont lieu au niveau d'un même appareil.

19. Procédé selon l'une des revendications 11 à 18, caractérisé en ce que la pièce ressort de ladite structure pour entrer dans une machine où est effectuée la dite opération de brasage ou d'étamage, la pièce étant, le cas échéant, entre la sortie de ladite structure et l'entrée de la dite machine, maintenue sous atmosphère protectrice.

20. Procédé selon l'une des revendications 11 à 18, caractérisé en ce que la dite opération de brasage ou d'étamage est réalisée au sein de la même dite structure, en aval du dit appareil ou des dits appareils.

21. Procédé selon la revendication 19 ou 20, caractérisé en ce que la pièce comportant la surface métallique à traiter est un circuit électronique et en ce que la dite opération ultérieure de brasage ou d'étamage est réalisée à la vague par mise en contact du circuit avec au moins une vague d'un alliage de soudure liquide, chaque face du circuit étant au préalable amenée en regard de la sortie de gaz d'au moins un dit appareil de formation d'espèces gazeuses excitées ou instables par le dit système de convoyage.

22. Procédé selon la revendication 21, caractérisé en ce que en aval de la dite mise en contact avec la ou les vagues de soudure, au moins une des faces du circuit est amenée en regard de la sortie de gaz d'au moins un appareil aval de formation d'espèces gazeuses excitées ou instables dans lequel on fait passer un mélange gazeux initial aval comprenant un gaz inerte et/ou un gaz réducteur et/ou un gaz oxydant, pour obtenir en sortie de gaz de l'appareil, un mélange gazeux primaire aval comprenant des espèces gazeuses excitées ou instables et substantiellement dépourvu d'espèces électriquement chargées.

23. Procédé selon l'une des revendications 21 ou 22, caractérisé en ce que durant tout ou partie de la dite mise en contact avec la ou les vagues de soudure, au moins une des faces du circuit est en contact avec la sortie de gaz d'au moins un appareil supplémentaire de formation d'espèces gazeuses excitées ou instables dans lequel on fait passer un mélange gazeux initial supplémentaire comprenant un gaz inerte et/ou un gaz réducteur et/ou un gaz oxydant, pour obtenir en sortie de gaz de l'appareil, un mélange gazeux primaire supplémentaire comprenant des espèces gazeuses excitées ou instables et substantiellement dépourvu d'espèces électriquement chargées.

24. Procédé selon l'une des revendications 21 à 23, caractérisé en ce que l'on met en place, en amont ou bien à l'entrée de la dite structure, des moyens de détection de l'arrivée du circuit à l'entrée de la dite structure, et en ce que suite à une action volontariste de l'utilisateur ou du fait qu'aucun circuit n'a été détecté à l'entrée de la dite structure durant une période de temps prédéfinie, on déclenche au moins l'une des mesures suivantes :
- on stoppe l'alimentation de chacun des dits appareils en mélange gazeux primaire;
- on maintient dans chaque appareil un débit réduit du mélange gazeux primaire qui circule dans l'appareil considéré:
- on fait passer, dans chaque appareil en lieu et place du mélange gazeux primaire qui circule dans l'appareil considéré, un mélange gazeux primaire d'attente;
- on stoppe l'alimentation en mélange gazeux adjacent mis en oeuvre au niveau d'au moins l'un des dits appareils;
- on met chaque appareil en régime d'attente où la densité d'énergie qui y est mise en oeuvre n'est que de quelques W/cm².

25. Procédé selon la revendication 19 ou 20, caractérisé en ce que la pièce comportant la surface métallique à traiter est un circuit électronique et en ce que la dite opération ultérieure de brasage est réalisée par refusion, au moins une des faces du circuit étant au préalable amenée en regard de la sortie de gaz d'au moins un dit appareil de formation d'espèces gazeuses excitées ou instables par le dit système de convoyage.

26. Procédé selon la revendication 25, caractérisé en ce que en aval de la dite opération de brasage par refusion, au moins une des faces du circuit est amenée en regard de la sortie de gaz d'au moins un appareil aval de formation d'espèces gazeuses excitées ou instables dans lequel on fait passer un mélange gazeux initial aval comprenant un gaz inerte et/ou un gaz réducteur et/ou un gaz oxydant, pour obtenir en sortie de gaz de l'appareil, un mélange gazeux primaire aval comprenant des espèces gazeuses excitées ou instables et substantiellement dépourvu d'espèces électriquement chargées.

27. Procédé selon l'une des revendications 25 ou 26, caractérisé en ce que durant tout ou partie de la dite opération de brasage par refusion, au moins une des faces du circuit est en contact avec la sortie de gaz d'au moins un appareil supplémentaire de formation d'espèces gazeuses excitées ou instables dans lequel on fait passer un mélange gazeux initial supplémentaire comprenant un gaz inerte et/ou un gaz réducteur et/ou un gaz oxydant, pour obtenir en sortie de gaz de l'appareil, un mélange gazeux primaire supplémentaire comprenant des espèces gazeuses excitées ou instables et substantiellement dépourvu d'espèces électriquement chargées.

28. Procédé selon l'une des revendications 25 à 27, caractérisé en ce que l'on met en place, en amont ou bien à l'entrée de la dite structure, des moyens de détection de l'arrivée du circuit à l'entrée de la dite structure, et en ce que suite à une action volontariste de l'utilisateur ou du fait qu'aucun circuit n'a été détecté à l'entrée de la dite structure durant une période de temps prédéfinie, on déclenche au moins l'une des mesures suivantes :
- on stoppe l'alimentation de chacun des dits appareils en mélange gazeux primaire;
- on maintient dans chaque appareil un débit réduit du mélange gazeux primaire qui circule dans l'appareil considéré;
- on fait passer, dans chaque appareil, en lieu et place du mélange gazeux primaire qui circule dans l'appareil considéré, un mélange gazeux primaire d'attente;
- on stoppe l'alimentation en mélange gazeux adjacent mis en oeuvre au niveau d'au moins l'un des dits appareils;
- on met chaque appareil en régime d'attente où la densité d'énergie qui y est mise en oeuvre n'est que de quelques W/cm².

## Claims

1. Method for dry fluxing at least one metallic surface of an article, before soldering or tinning using an alloy, characterized in that:
a) an initial gas mixture (7), comprising an inert gas and/or a reducing gas and including an oxidizing gas mixture which includes water vapour, is passed through at least one apparatus (11, 4, 12) for forming excited or unstable gas species, in order to obtain, after conversion in the apparatus, a primary gas mixture (8, 39, 40, 41) at the gas outlet (6) of the apparatus, the water vapour content of the initial gas mixture being in the range [50 ppm, 6 %];
b) the surface to be fluxed is treated, at a pressure close to atmospheric pressure, with a gaseous treatment atmosphere comprising excited or unstable gas species and substantially free of electrically charged species which is obtained from the said primary gas mixture.

2. Method according to Claim 1, characterized in that the said gaseous treatment atmosphere is obtained from the said primary gas mixture and an adjacent gas mixture (9, 10) which has not passed through the said apparatus.

3. Method according to one of Claims 1 or 2, characterized in that the water vapour content of the initial gas mixture is in the range [100 ppm, 1 %];

4. Method according to Claim 3, characterized in that the water vapour content of the initial gas mixture is in the range [500 ppm, 5000 ppm];

5. Method according to one of Claims 1 to 4, characterized in that the said oxidizing gas mixture contains oxygen in addition to water vapour.

6. Method according to one of Claims 1 to 4, characterized in that the said initial gas mixture consists of a nitrogen/hydrogen/water vapour mixture.

7. Method according to Claim 5, characterized in that the said initial gas mixture consists of a nitrogen/hydrogen/water vapour/oxygen mixture.

8. Method according to one of Claims 1 to 5, characterized in that the said initial gas mixture comprises hydrogen, and in that the hydrogen content of the initial gas mixture lies in the range [1000 ppm, 50 %], preferably less than or equal to 10 %.

9. Method according to one of Claims 1 to 8, characterized in that, during the treatment, the article to be treated is heated to a temperature of between ambient temperature and the melting temperature of the alloy used in order to carry out the subsequent soldering or tinning operation.

10. Method according to Claim 9, characterized in that the melting temperature of the said alloy is close to 180°C, and in that the said temperature to which the article to be treated is heated does not exceed 160°C.

11. Method according to one of Claims 1 to 10, characterized in that the article (1) having the said at least one metallic surface to be treated is brought in front of the gas outlet (6) of the said apparatus (4) by a conveyor system (2) which passes through an internal space (31) which is bounded by a covering structure (30) and is isolated from the surrounding atmosphere, the said structure being connected in a leaktight manner to the said apparatus or including the said apparatus.

12. Method according to one of Claims 1 to 10, characterized in that the article (1) having the said at least one metallic surface to be treated is brought in front of the gas outlets of a plurality of apparatuses placed in parallel over the width of the article and/or successively in front of the gas outlets of a plurality of apparatuses (11, 4, 12) placed in series, by a conveyor system (2) which passes through an internal space (31) which is bounded by a covering structure (30) and is isolated from the surrounding atmosphere, the said structure being connected in a leaktight manner to the said apparatuses or including the said apparatuses.

13. Method according to Claim 12, characterized in that at least one of the said apparatuses converts an initial gas mixture (7), which comprises an inert gas and/or a reducing gas, and an oxidizing gas mixture which includes water vapour.

14. Method according to Claim 11 or 12, characterized in that the said apparatus or at least one of the said apparatuses is the seat of an electric discharge created between a first electrode (14) and a second electrode (17), a layer (16) of a dielectric material being arranged on the surface of at least one of the electrodes (17), facing the other electrode, and in that the initial gas mixture which is converted in this apparatus passes through the discharge transversely to the electrodes.

15. Method according to Claim 14, characterized in that the power used in the said apparatus, normalized to unit surface area of dielectric, is greater than or equal to 1 W/cm², preferably greater than or equal to 10 W/cm².

16. Method according to Claim 12 in its relationship with Claim 1, characterized in that the treatment atmosphere successively encountered by the article to be treated along the conveyor is zoned in the following manner: at least one of the apparatuses (11, 4, 12) for forming excited or unstable gas species converts a different initial gas mixture (7) from that converted by the apparatus preceding it in the said structure (3).

17. Method according to Claim 12 in its relationship with Claim 2, characterized in that the treatment atmosphere successively encountered by the article to be treated along the conveyor is zoned in the following manner:
a) at least one of the apparatuses (11, 4, 12) for forming excited or unstable gas species converts a different initial gas mixture (7) from that converted by the apparatus preceding it in the said structure (3), and/or
b) the adjacent gas mixture (9, 10) employed in at least one of the apparatuses (11, 4, 12) for forming excited or unstable gas species is different from that employed in the apparatus preceding it in the said structure (3).

18. Method according to Claim 17, characterized in that steps a) and b) take place within one and the same apparatus.

19. Method according to one of Claims 11 to 18, characterized in that the article emerges from the said structure then enters a machine in which the said soldering or tinning operation is carried out, the article being, if appropriate, kept under a protective atmosphere between the exit of the said structure and the entry of the said machine.

20. Method according to one of Claims 11 to 18, characterized in that the said soldering or tinning operation is carried out within the same said structure, downstream of the said apparatus or of the said apparatuses.

21. Method according to Claim 19 or 20, characterized in that the article having the metallic surface to be treated is an electronic circuit, and in that the said subsequent soldering or tinning operation is carried out in wave mode by bringing the circuit into contact with at least one wave of a liquid solder alloy, each face of the circuit being previously brought in front of the gas outlet of at least one said apparatus for forming excited or unstable gas species, by the said conveyor system.

22. Method according to Claim 21, characterized in that downstream of the said contact with the solder wave or waves, at least one of the faces of the circuit is brought in front of the gas outlet of at least one downstream apparatus for forming excited or unstable gas species, through which a downstream initial gas mixture comprising an inert gas and/or a reducing gas and/or an oxidizing gas is passed, in order to obtain, at the gas outlet of the apparatus, a downstream primary gas mixture, comprising excited or unstable gas species and substantially free of electrically charged species.

23. Method according to one of Claims 21 or 22, characterized in that, during all or part of the said contact with the solder wave or waves, at least one of the faces of the circuit is in contact with the gas outlet of at least one additional apparatus for forming excited or unstable gas species, through which an additional initial gas mixture, comprising an inert gas and/or a reducing gas and/or an oxidizing gas, is passed in order to obtain, at the gas outlet of the apparatus, an additional primary gas mixture, comprising excited or unstable gas species and substantially free of electrically charged species.

24. Method according to one of Claims 21 to 23, characterized in that means for detecting the arrival of the circuit at the entry of the said structure are placed upstream of or else at the entry of the said structure, and in that at least one of the following measures is initiated as a result of an intentional action by the user or because no circuit has been detected at the entry of the said structure during a predetermined time period:
- the supply of primary gas mixture to each of the said apparatuses is stopped;
- a reduced flow rate of the primary gas mixture which circulates in the apparatus in question is maintained in each apparatus;
- instead of the primary gas mixture which circulates in the apparatus in question, a standby primary gas mixture is passed through each apparatus;
- the supply of adjacent gas mixture employed in at least one of the said apparatuses is stopped;
- each apparatus is placed in standby mode, in which the power density used therein is only a few W/cm².

25. Method according to Claim 19 or 20, characterized in that the article having the metallic surface to be treated is an electronic circuit, and in that the said subsequent soldering operation is carried out in reflow mode, at least one of the faces of the circuit being previously brought in front of the gas outlet of at least one said apparatus for forming excited or unstable gas species, by the said conveyor system.

26. Method according to Claim 25, characterized in that downstream of the said reflow soldering operation, at least one of the faces of the circuit is brought in front of the gas outlet of at least one downstream apparatus for forming excited or unstable gas species, through which a downstream initial gas mixture comprising an inert gas and/or a reducing gas and/or an oxidizing gas is passed, in order to obtain, at the gas outlet of the apparatus, a downstream primary gas mixture, comprising excited or unstable gas species and substantially free of electrically charged species.

27. Method according to one of Claims 25 or 26, characterized in that, during all or part of the said reflow soldering operation, at least one of the faces of the circuit is in contact with the gas outlet of at least one additional apparatus for forming excited or unstable gas species, through which an additional initial gas mixture, comprising an inert gas and/or a reducing gas and/or an oxidizing gas, is passed in order to obtain, at the gas outlet of the apparatus, an additional primary gas mixture, comprising excited or unstable gas species and substantially free of electrically charged species.

28. Method according to one of Claims 25 to 27, characterized in that means for detecting the arrival of the circuit at the entry of the said structure are placed upstream of or else at the entry of the said structure, and in that at least one of the following measures is initiated as a result of an intentional action by the user or because no circuit has been detected at the entry of the said structure during a predetermined time period:
- the supply of primary gas mixture to each of the said apparatuses is stopped;
- a reduced flow rate of the primary gas mixture which circulates in the apparatus in question is maintained in each apparatus;
- instead of the primary gas mixture which circulates in the apparatus in question, a standby primary gas mixture is passed through each apparatus;
- the supply of adjacent gas mixture employed in at least one of the said apparatuses is stopped;
- each apparatus is placed in standby mode, in which the power density used therein is only a few W/cm².

## Patentansprüche

1. Verfahren zum Trockenfluxen mindestens einer metallischen Oberfläche eines Werkstücks vor dem Löten oder Verzinnen mittels einer Legierung, dadurch gekennzeichnet, daß
a) ein Ausgangsgasgemisch (7), welches ein Inertgas und/oder ein reduzierendes Gas enthält und ein oxidierendes Gasgemisch beinhaltet, welches Wasserdampf beinhaltet, in mindestens eine Vorrichtung (11, 4, 12) zur Bildung angeregter oder instabiler Gasspezies eingeleitet wird, um nach der Umwandlung in der Vorrichtung am Gasauslaß (6) der Vorrichtung ein Primärgasgemisch (8, 39, 40, 41) zu erhalten, wobei der Wasserdampfgehalt des Ausgangsgasgemisches im Bereich von [50 ppm, 6%] liegt;
b) die zu fluxende Oberfläche bei einem Druck nahe Atmosphärendruck durch eine angeregte oder instabile Gaspezies enthaltende und von elektrisch geladenen Spezies im wesentlichen freie Behandlungsgasatmosphäre behandelt wird, die aus dem Primärgasgemisch erhalten wird.

2. Verfahren nach Anspruch 1, dadurch gekennzeichnet, daß die Behandlungsgasatmosphäre aus Primärgasgemisch und einem benachbarten Gasgemisch (9, 10) erhalten wird, das nicht durch die Vorrichtung geströmt ist.

3. Verfahren nach einem der Ansprüche 1 oder 2, dadurch gekennzeichnet, daß der Wasserdampfgehalt des Ausgangsgasgemischs im Bereich von [100 ppm, 1%] liegt.

4. Verfahren nach Anspruch 3, dadurch gekennzeichnet, daß der Wasserdampfgehalt des Ausgangsgasgemischs im Bereich von [500 ppm, 5000 ppm] liegt.

5. Verfahren nach einem der Ansprüche 1 bis 4, dadurch gekennzeichnet, daß das oxidierende Gasgemisch neben Wasserdampf Sauerstoff enthält.

6. Verfahren nach einem der Ansprüche 1 bis 4, dadurch gekennzeichnet, daß das Ausgangsgasgemisch aus einem Gemisch Stickstoff/Wasserstoff/Wasserdampf besteht.

7. Verfahren nach Anspruch 5, dadurch gekennzeichnet, daß das Ausgangsgasgemisch aus einem Gemisch Stickstoff/Wasserstoff/Wasserdampf/Sauerstoff besteht.

8. Verfahren nach einem der Ansprüche 1 bis 5, dadurch gekennzeichnet, daß das Ausgangsgasgemisch Wasserstoff enthält und daß der Wasserstoffgehalt des Ausgangsgasgemischs im Bereich [1000 ppm, 50%] liegt und vorzugsweise kleiner oder gleich 10% ist.

9. Verfahren nach einem der Ansprüche 1 bis 8, dadurch gekennzeichnet, daß das zu behandelnde Werkstück während der Behandlung auf einer Temperatur gehalten wird, die zwischen der Umgebungstemperatur und der Schmelztemperatur der Legierung liegt, die zur Durchführung des späteren Löt- oder Verzinnungsvorgangs verwendet wird.

10. Verfahren nach Anspruch 9, dadurch gekennzeichnet, daß die Schmelztemperatur der Legierung nahe bei 180°C liegt und die Temperatur, auf der das zu behandelnde Werkstück gehalten wird, 160°C nicht übersteigt.

11. Verfahren nach einem der Ansprüche 1 bis 10, dadurch gekennzeichnet, daß das die mindestens eine zu behandelnde metallische Oberfläche aufweisende Werkstück (1) in eine Position gegenüber dem Gasauslaß (6) der Vorrichtung (4) geführt wird durch eine Transporteinrichtung (2), die durch einen von einem Verkleidungsaufbau (3) umschlossenen, von der Umgebungsatmosphäre isolierten Innenraum (31) führt, wobei der Aufbau mit der Vorrichtung hermetisch verbunden ist oder die Vorrichtung umschließt.

12. Verfahren nach einem der Ansprüche 1 bis 10, dadurch gekennzeichnet, daß das die mindestens eine zu behandelnde metallische Oberfläche aufweisende Werkstück (1) in eine Position gegenüber den Gasauslässen mehrerer Vorrichtungen, die parallel zur Längsausdehnung des Werkstücks angeordnet sind, und/oder nacheinander in Positionen gegenüber Gasauslässen mehrerer in Reihe angeordneter Vorrichtungen (11, 4, 12) geführt wird durch eine Transporteinrichtung (2), die durch einen von einem Verkleidungsaufbau (3) umschlossenen, von der Umgebungsatmosphäre isolierten Innenraum (31) führt, wobei der Aufbau mit den Vorrichtungen hermetisch verbunden ist oder die Vorrichtungen umschließt.

13. Verfahren nach Anspruch 12, dadurch gekennzeichnet, daß mindestens eine der Vorrichtungen ein Ausgangsgasgemisch (7), das ein Inertgas und/oder ein reduzierendes Gas enthält, und ein oxidierendes Gasgemisch, das aus Wasserdampf besteht, umwandelt.

14. Verfahren nach Anspruch 11 oder 12, dadurch gekennzeichnet, daß die Vorrichtung oder mindestens eine der Vorrichtungen der Ort einer elektrischen Entladung ist, die zwischen einer ersten Elektrode (14) und einer zweiten Elektrode (17) erzeugt wird, wobei eine Schicht (16) eines dielektrischen Materials auf der Oberfläche mindestens einer der Elektroden (17) gegenüber der anderen Elektrode angeordnet ist, und daß das Ausgangsgasgemisch, das in dieser Vorrichtung umgewandelt wird, die Entladung quer zu den Elektroden durchstromt.

15. Verfahren nach Anspruch 14, dadurch gekennzeichnet, daß die in der Vorrichtung eingesetzte Energie bezogen auf die Flächeneinheit des Dielektrikums größer oder gleich 1 W/cm², vorzugsweise größer oder gleich 10 W/cm² ist.

16. Verfahren nach Anspruch 12 in seiner Rückbeziehung auf Anspruch 1, dadurch gekennzeichnet, daß die Behandlungsatmosphäre, die von dem zu behandelnden Werkstück längs der Transporteinrichtung nacheinander angetroffen wird, in folgender Weise in Zonen unterteilt wird: mindestens eine der Vorrichtungen (11, 4, 12) zur Bildung angeregter oder instabiler Gasspezies wandelt ein Ausgangsgasgemisch (7) um, das von demjenigen verschieden ist, das durch die in dem Aufbau (3) vorhergehende Vorrichtung umgewandelt wird.

17. Verfahren nach Anspruch 12 in seiner Rückbeziehung auf Anspruch 2, dadurch gekennzeichnet, daß die Behandlungsatmosphäre, die von dem zu behandelnden Werkstück längs der Transporteinrichtung nacheinander angetroffen wird, in folgender Weise in Zonen unterteilt wird:
a) mindestens eine der Vorrichtungen (11, 4, 12) zur Bildung angeregter oder instabiler Gasspezies wandelt ein Ausgangsgasgemisch (7) um, das von demjenigen verschieden ist, das durch die in dem Aufbau (3) vorhergehende Vorrichtung umgewandelt wird, und/oder
b) das benachbarte Gasgemisch (9, 10), das auf der Höhe mindestens einer der Vorrichtungen (11, 4, 12) zur Bildung angeregter oder instabiler Gasspezies eingesetzt wird, ist von demjenigen verschieden, das auf Höhe der in dem Aufbau (3) vorhergehenden Vorrichtung eingesetzt wird.

18. Verfahren nach Anspruch 17, dadurch gekennzeichnet, daß die Schritte a) und b) auf Höhe ein und derselben Vorrichtung stattfinden.

19. Verfahren nach einem der Ansprüche 11 bis 18, dadurch gekennzeichnet, daß das Werkstück aus dem Aufbau aus- und in eine Maschine eintritt, in welcher der Löt- oder Verzinnungsvorgang durchgeführt wird, wobei das Werkstück gegebenenfalls zwischen dem Ausgang des Aufbaus und dem Eingang der Maschine unter einer Schutzgasatmosphäre gehalten wird.

20. Verfahren nach einem der Ansprüche 11 bis 18, dadurch gekennzeichnet, daß der Löt- oder Verzinnungsvorgang innerhalb desselben Aufbaus, stromabwärts von der Vorrichtung oder den Vorrichtungen durchgeführt wird.

21. Verfahren nach Anspruch 19 oder 20, dadurch gekennzeichnet, daß das die zu behandelnde metallische Oberfläche aufweisende Werkstück eine elektronische Schaltung ist und daß der spätere Löt- oder Verzinnungsvorgang durch Anschwemmlöten durchgeführt wird, indem die Schaltung mit mindestens einer Welle einer Legierung flüssigen Lots in Kontakt gebracht wird, wobei jede Seite der Schaltung zuvor von der Transporteinrichtung in eine Position gegenüber dem Gasauslaß mindestens einer Vorrichtung zur Bildung angeregter oder instabiler Gasspezies gebracht wird.

22. Verfahren nach Anspruch 21, dadurch gekennzeichnet, daß stromabwärts von der Inkontaktbringung mit der oder den Lotwellen mindestens eine der Seiten der Schaltung in eine Position gegenüber dem Gasauslaß mindestens einer stromabwärts liegenden Vorrichtung zur Bildung angeregter oder instabiler Gasspezies gebracht wird, in die ein stromabwärtiges Ausgangsgasgemisch eingeleitet wird, das ein Inertgas und/oder ein reduzierendes Gas und/oder ein oxidierendes Gas enthält, um am Gasauslaß der Vorrichtung ein stromabwärtiges Primärgasgemisch zu erhalten, das angeregte oder instabile Gasspezies enthält und im wesentlichen frei von elektrisch geladenen Spezies ist.

23. Verfahren nach einem der Ansprüche 21 oder 22, dadurch gekennzeichnet, daß während der ganzen oder während eines Teils der Inkontaktbringung mit der oder den Lotwellen mindestens eine der Seiten der Schaltung Kontakt mit dem Gasauslaß mindestens einer zusätzlichen Vorrichtung zur Bildung angeregter oder instabiler Gasspezies hat, in die ein zusätzliches Ausgangsgasgemisch eingeleitet wird, das ein Inertgas und/oder ein reduzierendes Gas und/oder ein oxidierendes Gas beinhaltet, um am Gasauslaß der Vorrichtung ein zusätzliches Primärgasgemisch zu erhalten, das angeregte oder instabile Gasspezies enthält und im wesentlichen frei von elektrisch geladenen Spezies ist.

24. Verfahren nach einem der Ansprüche 21 bis 23, dadurch gekennzeichnet, daß stromaufwärts oder auch am Eingang des Aufbaus Mittel zur Erfassung des Eintreffens der Schaltung am Eingang des Aufbaus angeordnet sind, und daß infolge einer willentlichen Aktion des Benutzers oder deswegen, weil am Eingang des Aufbaus während einer vorbestimmten Zeitspanne keine Schaltung erfaßt wurde, mindestens eine der folgenden Maßnahmen ausgelöst wird:
- die Versorgung jeder Vorrichtung mit Primärgasgemisch wird unterbrochen;
- in jeder Vorrichtung wird ein reduzierter Fluß des Primärgasgemischs, das in der betreffenden Vorrichtung zirkuliert, aufrechterhalten;
- in jede Vorrichtung wird anstelle des Primärgasgemischs, das in der betreffenden Vorrichtung zirkuliert, ein Bereitschaftsprimärgasgemisch eingeleitet;
- die Versorgung mit einem benachbarten Gasgemisch, das auf Höhe mindestens einer der Vorrichtungen eingesetzt wird, wird unterbrochen;
- jede Vorrichtung wird in einen Bereitschaftszustand versetzt, wobei die Energiedichte, die dabei eingesetzt wird, nur wenige W/cm² beträgt.

25. Verfahren nach Anspruch 19 oder 20, dadurch gekennzeichnet, daß das die zu behandelnde metallische Oberfläche aufweisende Werkstück eine elektronische Schaltung ist und daß der spätere Lötvorgang durch Aufschmelzen erfolgt, wobei mindestens eine der Seiten der Schaltung zuvor von der Transporteinrichtung in eine Position gegenüber dem Gasauslaß mindestens einer Vorrichtung zur Bildung angeregter oder instabiler Gasspezies gebracht wird.

26. Verfahren nach Anspruch 25, dadurch gekennzeichnet, daß stromabwärts von dem Lötvorgang durch Aufschmelzen mindestens eine der Seiten der Schaltung in eine Position gegenüber dem Gasauslaß mindestens einer stromabwärts liegenden Vorrichtung zur Bildung angeregter oder instabiler Gasspezies gebracht wird, in die ein stromabwärtiges Ausgangsgasgemisch eingeleitet wird, das ein Inertgas und/oder ein reduzierendes Gas und/oder ein oxidierendes Gas enthält, um am Gasauslaß der Vorrichtung ein stromabwärtiges Primärgasgemisch zu erhalten, das angeregte oder instabile Gasspezies enthält und im wesentlichen frei von elektrisch geladenen Spezies ist.

27. Verfahren nach einem der Ansprüche 25 oder 26, dadurch gekennzeichnet, daß während des ganzen oder während eines Teils des Lötvorgangs durch Aufschmelzen mindestens eine der Seiten der Schaltung Kontakt mit dem Gasauslaß mindestens einer zusätzlichen Vorrichtung zur Bildung angeregter oder instabiler Gasspezies hat, in die ein zusätzliches stromabwärtiges Ausgangsgasgemisch eingeleitet wird, das ein Inertgas und/oder ein reduzierendes Gas und/oder ein oxidierendes Gas beinhaltet, um am Gasauslaß der Vorrichtung ein zusätzliches Primärgasgemisch zu erhalten, das angeregte oder instabile Gasspezies enthält und im wesentlichen frei von elektrisch geladenen Spezies ist.

28. Verfahren nach einem der Ansprüche 25 bis 27, dadurch gekennzeichnet, daß stromaufwärts oder auch am Eingang des Aufbaus Mittel zur Erfassung des Eintreffens der Schaltung am Eingang des Aufbaus angeordnet sind, und daß infolge einer willentlichen Aktion des Benutzers oder deswegen, weil am Eingang des Aufbaus während einer vorbestimmten Zeitspanne keine Schaltung erfaßt wurde, mindestens eine der folgenden Maßnahmen ausgelöst wird:
- die Versorgung jeder Vorrichtung mit Primärgasgemisch wird unterbrochen;
- in jeder Vorrichtung wird ein reduzierter Fluß des Primärgasgemischs, das in der betreffenden Vorrichtung zirkuliert, aufrechterhalten;
- in jede Vorrichtung wird anstelle des Primärgasgemischs, das in der betreffenden Vorrichtung zirkuliert, ein Bereitschaftsprimärgasgemisch eingeleitet;
- die Versorgung mit einem benachbarten Gasgemisch, das auf Höhe mindestens einer der Vorrichtungen eingesetzt wird, wird unterbrochen;
- jede Vorrichtung wird in einen Bereitschaftszustand versetzt, wobei die Energiedichte, die dabei eingesetzt wird, nur wenige W/cm² beträgt.
